# EUROPEAN PATENT SPECIFICATION

(11) **EP 0 801 423 B1**
(45) Date of publication and mention of the grant of the patent: **17.09.2008**
(21) Application number: 97105477.0
(22) Date of filing: 02.04.1997
(51) Int. Cl.: H01L 21/68, H01L 21/48

(54) **Hdmi decal and fine line flexible interconnect forming methods**
Herstellungsmethode einer HDMI-Abziehstruktur und einer flexiblen Feinlinien-Verbindung
Méthode de fabrication d'une interconnexion à lignes fines flexibles et d'une structure transférable HDMI

(30) Priority: 08.04.1996 US 629956
(43) Date of publication of application: 15.10.1997
(73) Proprietor: RAYTHEON COMPANY, Lexington, Massachusetts 02173 (US)
(72) Inventor: Bakhit, Gabriel G., Huntington Beach, CA 82646 (US); Pillai, Vincent, Irvine, CA 92714 (US); Averkiou, George, Upland, CA 91784 (US); Trask, Philip A., Laguna Hills, CA 92653 (US)
(74) Representative: Witte, Alexander

(56) References cited:
- US-A- 4 306 925
- US-A- 4 980 034
- US-A- 5 192 716
- US-A- 5 262 351

## Description

### BACKGROUND

The present invention relates generally to processing methods for forming high density multichip interconnect (HDMI) structures, and more particularly, to methods of forming flexible HDMI decals comprising flexible fine line interconnect structures.

Conventional flexible interconnect manufacturing techniques are limited in terms of the available materials that may be used and the line densities that may be achieved. The latest generation integrated circuits (IC), liquid crystal displays, three dimensional electronic structures, and infrared detectors impose a greater demand for higher density interconnects with improved thermal, environmental stability and lower cost.

Presently available state of the art flexible interconnect cables are fabricated in a non-integrated circuit fabrication environment that limits their fine line density. Generally, conventional flexible connection cables are formed by applying an adhesive layer between each of the multiple layers to hold them together. This limits the operating temperature and the thermal stability of the fabricated flexible interconnect cables. Interconnect metallization in the conventional flexible interconnection cables is typically formed using copper which is not a radiation, hardened material and is not optimal for using power and radiation-hardened space and military applications.

US 5,262,351 discloses a method of producing a multi-layer polymer-metal system to interconnect integrated circuits which allows two-dimensional electrical and/or optical connections between components, in which a first layer of polymer is deposited on a rigid substrate such that the layer can be separated from the substrate, in which a multi-layer interconnection system is then produced on this first layer using industrial methods and in which the rigid substrate is removed after installation and connection of the integrated circuit.

US 5,192,716 discloses a semiconductor structure which is provided by forming a thin film multi-layer wiring decal on a support substrate and aligning and attaching one or more integrated chips to the decall. A support ring is attached to the decal surrounding the aligned and attached integrated substrate, and the support substrate is removed by using etching techniques.

It is an objective of the present invention to provide for methods of forming flexible HDMI decals comprising flexible fine line HDMI interconnect structures.

### SUMMARY OF THE INVENTION

To meet the above and other objectives, the present invention provides for methods of forming a plurality of high density multilayer interconnect (HDMI) structures on a relatively large carrier or substrate and subsequently releasing one or more of the HDMI interconnect structures to provide useable flexible interconnects or decals. In general, a carrier is provided and a release layer is formed on the carrier. A flexible high density multilayer interconnect (HDMI) structure is then fabricated on the release layer. Finally, the release layer is processed to release and remove one or more flexible HDMI structures from the carrier.

The carrier comprises a rigid ultraviolet transparent substrate or wafer. The release layer is formed on the ultraviolet transparent carrier that is subsequently processed to release the HDMI interconnect structures from the carrier. The release layer may comprise a polyimide layer.

The plurality of HDMI structures are formed on the carrier and release layer using well-known MCM-D processing techniques. Each of the HDMI structures comprise layers of polyimide having aluminum or copper fine line interconnects and vias formed therethrough that provide signal paths from bond pads disposed at a surface of the HDMI structure to other bond pads that are used to connect to electronic components.

Once the plurality of HDMI structures are formed on the release layer, a short wavelength ultraviolet radiation source, which may be programmable and controllable, is used to release individual ones of the HDMI structures. Alternatively, a flood beam ultraviolet radiation source may be used to release many or all of the HDMI structures from the ultraviolet transparent carrier. The ultraviolet source is caused to radiate ultraviolet radiation through the transparent carrier and onto the release layer disposed between the fabricated HDMI structures and the carrier. For example, a controllable ultraviolet laser may be used to selectively irradiate each of the HDMI structures, in conjunction with a programmable pick and place machine, for example, to release and remove it from the release layer and carrier.

To achieve the removal of HDMI structures, ultraviolet radiation (photons) from the ultraviolet source interacts with the polyimide layer adjacent to the carrier and ruptures or otherwise breaks the adhesive bond therebetween. This permits the HDMI structures to be lifted off of the carrier using the programmable pick and place machine or other tool. Multiple HDMI structures may be released from the carrier using the wide area ultraviolet source in a similar manner.

The present invention achieves or exceeds currently producible fine line density and stability demands for flexible interconnects by using improved materials (polyimide and aluminum or copper) and an improved manufacturing technique for making fine line flexible interconnect structures by fabricating them on the ultraviolet transparent carrier and releasing them by irradiating them individually or in mass using ultraviolet radiation. The present invention allows the formation of all aluminum (radiation hardened) flexible high density multilayer interconnect (HDMI) structures that may be used in space and other military electronic systems.

The present invention allows high density unimetallization (aluminum) to be used to form the fine line metallized conductors, which is ideal for power devices. The present invention also provides for a 95% reduction in weight compared to presently available HDMI substrates used in electronics designed for military aircraft and space systems developed by the assignee of the present invention. The present invention has diverse commercial applications where fine pitch interconnects are needed, such as for three-dimensional flexible cables, and membrane IC test boards, and the like, that are to be used at relatively high temperatures, on the order of 165 degrees Celsius.

### BRIEF DESCRIPTION OF THE DRAWINGS

The various features and advantages of the present invention may be more readily understood with reference to the following detailed description taken in conjunction with the accompanying drawings, wherein like reference numerals designate like structural elements, and in which:
Fig 1 is a cross sectional side view showing fabrication of a flexible high density multilayer interconnect structure formed using methods in accordance with the principles of the present invention; and
Fig. 2 shows a flow diagram illustrating details of the present method.

### DETAILED DESCRIPTION

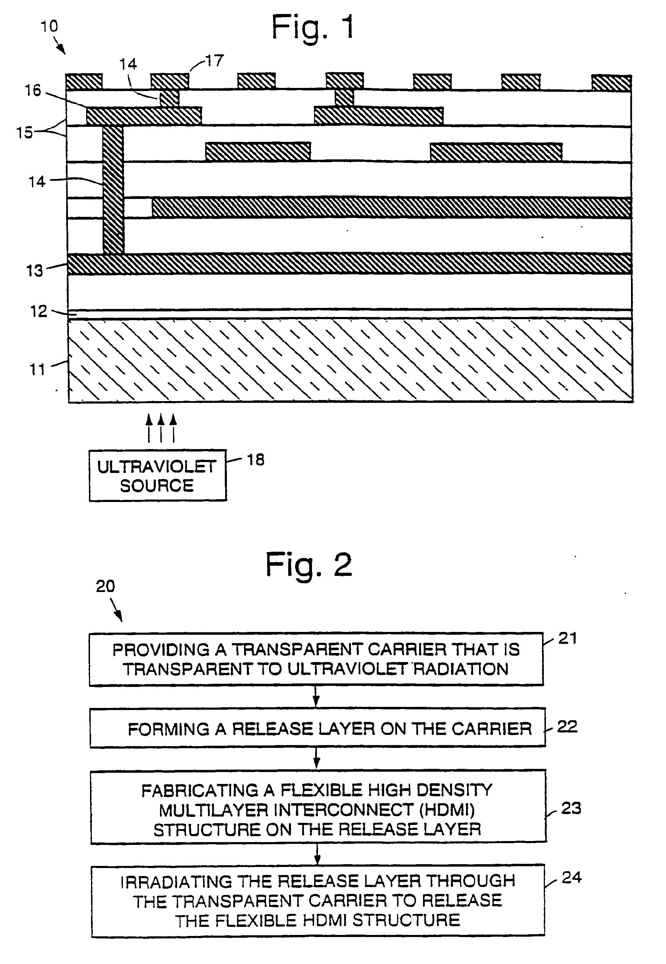

Referring to the drawing figures, Fig 1 is a cross sectional side view showing fabrication of a flexible high density multilayer interconnect (HDMI structure 10 formed using methods 20 in accordance with the principles of the present invention. The flexible HDMI structure 10 is fabricated on a relatively large carrier 11, typically having dimensions on the order of two feet by two feet. The carrier 11 comprises an ultraviolet transparent substrate or wafer, such as quartz, for example.

The carrier 11 has a release layer 12 formed or otherwise deposited thereon. A polyimide layer is deposited as the release layer 12.

The flexible HDMI structure 10 is comprised of a plurality of dielectric layers 15 having fine line metallization patterns 13 formed therethrough that terminate at bond pads 17 on one or more surfaces of the fabricated flexible HDMI structure 10 and at cooperative bond pads (not shown) that are connected to electronic components. For example, each of the HDMI structures 10 may comprise dielectric layers 15 comprising polyimide having aluminum fine line interconnects 13,16 and vias 14 formed therethrough that provide signal paths from the bond pads 17 disposed at the surface of the HDMI structure 10 to other bond pads that are connected to the electronic components. The plurality of HDMI structures 10 are formed on the carrier 11 and release layer 12 using well-known MCM-D processing techniques. Processing that may be used to fabricate the HDMI structures 10 is described in U.S. Patent No. 5,034,091, entitled "Method of Forming an Electrical Via Structure", and assigned to the assignee of the present invention.

The release layer 12 is processed to release or remove one or more fabricated HDMI interconnect structures 10 from the carrier 11. More specifically, once the plurality of HDMI structures 10 are formed, a short wavelength ultraviolet radiation source 18, which is programmable and controlled, is used to release individual ones of the HDMI structures 10. A programmable pick and place machine may be used to physically remove the HDMI structures 10 once they are released from the carrier 11.

Alternatively, a flood beam ultraviolet radiation source 18 may be used to release many or all of the HDMI structures 10 from the ultraviolet transparent substrate or carrier 11. The ultraviolet radiation source 18 is caused to radiate ultraviolet radiation through the ultraviolet transparent carrier 11 and onto the release layer 12. For example, an ultraviolet laser may be used to selectively irradiate one of the HDMI structures 10 to release it from the release layer 12.

The ultraviolet radiation (photons) from the ultraviolet radiation source 18 interacts with the polyimide release layer 12 adjacent to the carrier 11 and ruptures or otherwise breaks the adhesive bond therebetween. This permits the HDMI structures 10 to be lifted off of the carrier 11 using the programmable pick and place machine or other tool, for example. Multiple HDMI structures 10 may be released from the carrier 11 using a wide area ultraviolet radiation source 18 in a similar manner.

The present invention achieves or exceeds currently producible fine line density and stability demands for flexible interconnects. The present invention uses improved materials such as polyimide and aluminum to form the HDMI interconnect structures 10 and an improved manufacturing technique for making and releasing the HDMI structures 10 from the carrier 11 either individually or in mass. The present invention allows the formation of all aluminum (radiation hardened) flexible HDMI structures 10 that may be used in space and other military electronic systems.

The present invention allows high density unimetallization (aluminum or copper) to be used to form the fine line metallized interconnects 13,16 and vias 14, which is ideal for power devices. The present invention also provides for a 95% reduction in weight compared to presently available flexible HDMI substrates of the same size that are currently used in electronics designed for military aircraft and space systems developed by the assignee of the present invention. The present invention has diverse commercial applications where fine pitch interconnects are needed, such as for three-dimensional flexible cables, and membrane IC test boards, and the like, that are to be used at relatively high temperatures, on the order of 165 degrees Celsius.

For the purposes of completeness, Fig. 2 shows a flow diagram illustrating method 20 in accordance with the present invention for forming flexible HDMI structures 10 on a carrier 11 and subsequently releasing the HDMI interconnect 35 structures 10 either individually or in total from the carrier 11. The present method 20 is as follows.

Referring to Fig. 2, a method 20 comprises the steps of providing 21 a transparent carrier 11 that is transparent to ultraviolet radiation, forming 22 a release layer 12 on the transparent carrier 11, fabricating 23 flexible high density multilayer interconnect (HDMI) structures 10 on the release layer 12, and processing 24 the release layer 12 to release the flexible HDMI structures 10 from the rigid carrier 11, such as by irradiating the release layer 12 through the transparent carrier 11 using an ultraviolet radiation source 18.

Thus, a method for forming flexible HDMI decals comprising flexible fine line interconnect structures has been disclosed. It is to be understood that the described embodiments are merely illustrative of some of the many specific embodiments which represent applications of the principles of the present invention. Clearly, numerous and varied other arrangements may be readily devised by those skilled in the art without departing from the scope of the invention.

## Claims

1. A method of fabricating flexible high density multilayer interconnect (HDMI) structures (10), **characterized by** the steps of:
- providing (21) a carrier (11) transparent to ultraviolet radiation;
- forming (22) a release layer (12) on said carrier (11);
- fabricating (23) a flexible HDMI structure (10) on said release layer (12); and
- processing (24) said release layer (12) to release and remove said flexible HDMI structure (10) from said carrier (11), comprising irradiating said release layer (12) through said carrier (11) with ultraviolet radiation.

2. The method of claim 1, **characterized in that** said step (21) of providing comprises providing a rigid carrier (11).

3. The method of claim 2, **characterized in that** said carrier (11) is made of quartz.

4. The method of any of claims 1 to 3, **characterized in that** said step (22) of forming includes forming said release layer (12) from polyimide.

5. The method of any of claims 1 to 4, **characterized by** the further step of providing said HDMI structure (10) with dielectric layers (15) having metal fine line interconnects (13, 16) and vias (14) formed therethrough that provide signal paths from bond pads (17) disposed at the surface of said HDMI structure (10) to associated electronic components.

## Patentansprüche

1. Verfahren zum Herstellen von flexiblen hoch integrierten mehrlagigen Verbindungs-(HDMI)Strukturen (10), **gekennzeichnet durch** die folgenden Schritte:
- Bereitstellen (21) eines Trägers (21), der für ultraviolette Strahlung transparent ist;
- Bilden (22) einer Freigabeschicht (12) auf dem Träger (11);
- Herstellen (23) einer flexiblen HDMI-Struktur (10) auf der Freigabeschicht (12); und
- Verarbeiten (24) der Freigabeschicht (12), um die flexiblen HDMI-Strukturen (10) freizugeben und vom Träger (11) zu lösen, aufweisend Bestrahlen der Freigabeschicht (12) **durch** den Träger (11) mit ultravioletter Strahlung.

2. Verfahren nach Anspruch 1, **dadurch gekennzeichnet, dass** der Schritt des Bereitstellens (21) das Bereitstellen eines starren Trägers (11) aufweist.

3. Verfahren nach Anspruch 2, **dadurch gekennzeichnet, dass** der Träger (11) aus Quarz gemacht ist.

4. Verfahren nach einem der Ansprüche 1 bis 3, **dadurch gekennzeichnet, dass** der Schritt des Bildens (22) das Bilden der Freigabeschicht (12) aus Polyimid aufweist.

5. Verfahren nach einem der Ansprüche 1 bis 4, **gekennzeichnet durch** den weiteren Schritt eines Ausgestaltens der HDMI-Struktur (10) mit dielektrischen Schichten (15), die metallische feinlinige Verbindungselemente (13, 16) und Durchgangslöcher (14) haben, die da **durch** gebildet sind, die Signalpfade von Verbindungsstellen (17), die an der Oberfläche der HDMI-Struktur (10) angeordnet sind, zu den zugeordneten elektronischen Komponenten bereitstellen.

## Revendications

1. Procédé de fabrication de structures (10) d'interconnexions multicouches à haute densité (HDMI) souples, **caractérisé par** les étapes consistant à :
- fournir (21) un support (11) transparent au rayonnement ultraviolet,
- former (22) une couche de séparation (12) sur ledit support (11),
- fabriquer (23) une structure d'interconnexions HDMI souple (10) sur ladite couche de séparation (12), et
- traiter (24) ladite couche de séparation (12) pour séparer et enlever ladite structure d'interconnexions HDMI souple (10) dudit support (11), comprenant l'irradiation de ladite couche de séparation (12) à travers ledit support (11) par un rayonnement ultraviolet.

2. Procédé selon la revendication 1, **caractérisé en ce que** ladite étape (21) de fourniture d'un support comprend la fourniture d'un support rigide (11).

3. Procédé selon la revendication 2, **caractérisé en ce que** ledit support (11) est fait de quartz.

4. Procédé selon l'une quelconque des revendications 1 à 3, **caractérisé en ce que** ladite étape (22) de formation d'une couche de séparation comprend la formation de ladite couche de séparation (12) à partir de polyimide.

5. Procédé selon l'une quelconque des revendications 1 à 4, **caractérisé par** l'étape supplémentaire consistant à doter ladite structure d'interconnexions HDMI (10) de couches de diélectriques (15) comportant des interconnexions à traits fins métalliques (13, 16) et des traversées (14) formées à travers celles-ci, qui fournissent des trajets de signaux à partir de plages de contact (17) disposées à la surface de ladite structure d'interconnexions HDMI (10) vers des composants électroniques associés.
